# EUROPÄISCHE PATENTSCHRIFT

(11) **EP 3 193 568 B1**
(45) Veröffentlichungstag und Bekanntmachung des Hinweises auf die Patenterteilung: **15.05.2019**
(21) Anmeldenummer: 17159040.9
(22) Anmeldetag: 10.12.2003
(51) Int. Cl.: H05K 3/30, H05K 3/32, H01R 12/58, H05K 3/00, H05K 1/11

(54) **SCHALTUNGSTRÄGER**
CIRCUIT CARRIER
SUPPORT DE CIRCUIT

(30) Priorität: 10.12.2002 DE 10257527
(43) Veröffentlichungstag der Anmeldung: 19.07.2017
(62) Teilanmeldung aus: 03028364.2
(73) Patentinhaber: Marquardt GmbH, 78604 Rietheim-Weilheim (DE)
(72) Erfinder: Neitzel, Roland, 78570 Mühlheim (DE); Stegerwald, Gerhard, 97816 Lohr am Main (DE)
(74) Vertreter: Otten, Roth, Dobler & Partner mbB Patentanwälte

(56) Entgegenhaltungen:
- DE-A1- 3 505 129
- FR-A1- 2 736 214
- FR-A1- 2 763 751
- GB-A- 1 356 143
- JP-A- H08 191 192
- US-A- 4 906 209
- US-A- 5 754 407
- US-B1- 6 215 667
- US-B1- 6 249 442

## Beschreibung

Die Erfindung eine elektrische Schaltung mit einem Schaltungsträger nach dem Oberbegriff des Patentanspruchs 1.

Solche elektrische Schaltungen mit derartigen Schaltungsträgern werden in Steuergeräten für Kraftfahrzeuge eingesetzt. Beispielsweise kann es sich um ein Steuergerät für den elektrischen Fensterheber, die Spiegelverstellung, die Zentralverriegelung o. dgl. handeln.

Auf dem Schaltungsträger ist eine elektrische Schaltung mit elektrischen, elektronischen o. dgl. Bauteilen, bei denen es sich beispielsweise um Elektromotoren, Schaltern, Widerständen, Kondensatoren, Spulen, ICs, Steckanschlüssen handeln kann, angeordnet. Weiter besitzt der Schaltungsträger zur elektrischen Verbindung der Bauteile dienende Leiterbahnen sowie zur elektrischen Kontaktierung der Bauteile dienende Kontaktflächen. Diese Schaltungsträger können starr oder auch in der Art einer wenigstens teilweise flexiblen Leiterplatte ausgestaltet sein.

Nachteilig bei den bekannten Schaltungsträgern ist, dass zur Kontaktierung der Bauteile mit den Kontaktflächen ein Verlöten oder Verkleben notwendig ist. Dies erfordert teurere und gegebenenfalls ökologisch bedenkliche Zusatzstoffe, beispielsweise Lötzinn oder Leitkleber. Außerdem ist ein zusätzlicher Verbindungsarbeitsgang, wie Schweißen, Aufheizen o. dgl., notwendig, was letztendlich die Montage des Schaltungsträgers verteuert.

Aus der DE 35 05 129 A1 ist eine lötfreie elektrische Verbindung zwischen einer flexiblen Leiterfolie und einem Bauelement bekannt. Bei dieser Verbindung ist die Kontaktfläche auf der Leiterfolie in der Ebene des Schaltungsträgers freigeschnitten, derart dass die Kontaktfläche eine Flexibilität in eine außerhalb der Ebene des Schaltungsträgers verlaufende Richtung in der Art einer Kontaktzunge aufweist. Ein in der Art eines Steckverbinders ausgestaltetes Kontaktelement liegt zur elektrischen Kontaktierung des Bauteils mit einem Anpressdruck derart an der Kontaktfläche an, dass die Kontaktfläche aus der Ebene des Schaltungsträgers ausgelenkt ist.

Eine solchermaßen ausgestaltete lötfreie elektrische Verbindung zwischen einer flexiblen Kontaktzunge und einem Kontaktelement ist auch in der FR 2 736 214 A, der DE 199 46 130 A1 und der US 3 843 951 A gezeigt. Des Weiteren ist in der US 5 042 971 A eine elektrische Verbindung durch Faltung von Filmleitern um elektrische Anschlüsse eines Bauteils sowie in der US 2002/142627 A1 eine elektrische Verbindung mittels eines Anschlussstiftes, der eine Leiterfolie durchdringt und mit einem flügelartigen Abschnitt zur elektrischen Kontaktierung an der Leiterfolie anliegt, zu sehen. Schließlich ist in der
DE 27 34 994 A1 ein Folienleiter beschrieben, der mittels einer thermoplastischen Niete auf einem Träger befestigt ist.

Der Erfindung liegt die Aufgabe zugrunde, den Schaltungsträger derart weiterzuentwickeln, dass auf die Verwendung von Zusatzstoffen sowie auf einen zusätzlichen Verbindungsarbeitsgang bei der Kontaktierung der Bauteile verzichtet werden kann, wobei der Schaltungsträger unter rauhen Einsatzbedingungen, wie beispielsweise im Kraftfahrzeugbereich, einsetzbar sein soll.

Diese Aufgabe wird bei einem gattungsgemäßen Schaltungsträger durch die kennzeichnenden Merkmale des Anspruchs 1 gelöst. Ein entsprechendes Verfahren zur Herstellung eines derartigen Schaltungsträgers ist im Anspruch 5 angegeben. Beim erfindungsgemäßen Schaltungsträger ist die Kontaktfläche wenigstens teilweise in der Ebene des Schaltungsträgers freigeschnitten, derart dass die Kontaktfläche eine Flexibilität in eine außerhalb der Ebene des Schaltungsträgers verlaufende Richtung aufweist und somit eine Art von Kontaktzunge bildet. Ein Kontaktelement zur elektrischen Kontaktierung des Bauteils liegt mit einem Anpressdruck derart an der Kontaktfläche an, dass die Kontaktfläche aus der Ebene des Schaltungsträgers ausgelenkt ist. Das Kontaktelement ist in der Art eines Steckverbinders ausgebildet. Hierzu besitzt das Kontaktelement einen wenigstens teilweise freigeschnittenen Abschnitt. Nachdem das Kontaktelement in die Aufnahme eingesteckt ist, befindet sich dieser freigeschnittene Abschnitt dann in der Aufnahme und liegt zur Kontaktgabe mit einer Andrückkraft an der Kontaktfläche an. Der freigeschnittene Abschnitt lässt sich in fertigungstechnisch einfacher Art als eine federartige Zunge, ein federnder Schenkel o. dgl. ausgestalten. Beispielsweise kann eine solche federnde Zunge durch einen U-förmigen Einschnitt mit anschließender Ausklinkung der Zunge in ein entsprechendes Flachmaterial hergestellt werden.

Diese Ausgestaltung gestattet somit in einfacher Art und Weise eine lotfreie Verbindung des Bauteils mit der Kontaktfläche. Weitere Ausgestaltungen der Erfindung sind Gegenstand der Unteransprüche.

Erfindungsgemäß handelt es sich bei dem Schaltungsträger um eine flexible Schaltungsträgerfolie, so dass die Kontaktfläche bereits ohne weitere Maßnahmen über die erforderliche Biegefähigkeit verfügt. Die Folie einer solchen Schaltungsträgerfolie kann aus Polyimid, Polyethylennaphtalat o. dgl. bestehen, wobei die Leiterbahnen in herkömmlicher Weise aus Kupfer auf der Folienoberfläche aufgebracht sind. Die Kontaktfläche kann dann in einfacher Weise als freigeschnittenes und/oder freiliegendes Ende einer Leiterbahn ausgestaltet sein. Zweckmäßigerweise ist der Zungengrund an der Folie des freiliegenden Endes abgerundet, um ein Einreißen der Schaltungsträgerfolie bei Montage des Kontaktelements zu verhindern.

Um trotz der Flexibilität der Schaltungsträgerfolie die notwendige Stabilität für die Montage im Steuergerät o. dgl. zu gewährleisten, bietet es sich an, die Schaltungsträgerfolie an einem Trägerelement anzuordnen. Das Trägerelement besteht aus Kunststoff und kann beispielsweise in Spritzgießtechnik hergestellt sein. Das Trägerelement mitsamt der darauf befestigten Schaltungsträgerfolie bildet dann eine Art von Elektrokomponententräger. Weiter wird dadurch eine definierte Lage der Kontaktflächen ohne zusätzliche Haltevorrichtungen erreicht. Außerdem werden Kräfte auf die Folie beim Anbringen der Kontaktelemente durch das Trägerelement aufgenommen. Schließlich werden auch Rissbildungen in der Schaltungsträgerfolie bei Schwingungen, wie sie beispielsweise beim Einsatz im Kraftfahrzeug auftreten können, wirksam verhindert.

Zur Befestigung der Schaltungsträgerfolie auf dem Trägerelement ist ein Hinterspritzen der Schaltungsträgerfolie mit dem Trägerelement möglich.
Eine einfache Montage des Kontaktelements, die sich dennoch durch eine besondere Kontaktsicherheit des Kontaktelements auszeichnet, ist dadurch gegeben, dass im Trägerelement eine Aufnahme, eine Ausnehmung, eine Ausformung o. dgl. angebracht ist. Die Kontaktfläche ragt in diese Aufnahme hinein, und das Kontaktelement ist kraft- und/oder formschlüssig in die Aufnahme eingesteckt. Dadurch liegt das Kontaktelement an der Kontaktfläche mit dem nötigen Anpressdruck an. Zur Erhöhung der Haltekraft des Kontaktelements in der Aufnahme kann eine Verzahnung am Kontaktelement verwendet werden, so dass sich das in die Aufnahme eingesteckte Kontaktelement im Material der Aufnahme eingräbt.

Bei dem Flachmaterial für das Kontaktelement kann es sich um Bronzeblech handeln, dessen Oberfläche bei Bedarf noch verzinnt sein kann. Falls gewünscht, kann zur Ausübung und/oder Erhöhung der Anpresskraft des freigeschnittenen Abschnittes an die Kontaktfläche in der Aufnahme eine keilförmige Erhöhung, ein federnder Steg o. dgl. angeordnet sein.

Das Kontaktelement kann bereits am Bauteil bei dessen Herstellung befestigt werden. Handelt es sich bei dem Bauteil um einen elektrischen Schalter, so bietet es sich in diesem Fall an, dessen Anschlüsse in der Form von Kontaktelementen auszugestalten. Alternativ kann es sich beim Kontaktelement auch um ein bezüglich des Bauteils separates Teil handeln. Beispielsweise lässt sich ein handelsüblicher Elektromotor mittels eines solchen separaten Kontaktelements mit der Kontaktfläche in einfacher Weise elektrisch verbinden. Das Kontaktelement kann seinerseits eine Schneidklemm-Kontaktierung zum Bauteil aufweisen, um die elektrische Verbindung zum Bauteil in einfacher Art und Weise herzustellen.

Zur Herstellung eines erfindungsgemäßen Schaltungsträgers ist zum einen nachfolgendes Herstellverfahren besonders bevorzugt. Die Schaltungsträgerfolie wird derart auf dem Trägerelement platziert, dass die Kontaktflächen im Bereich der Aufnahme befindlich sind. Anschließend wird das Kontaktelement in die Aufnahme eingeführt, so dass das Kontaktelement bei der Montage die Kontaktfläche in die Aufnahme mit hineinzieht. Dadurch liegt dann nach der Montage das Kontaktelement mit einem Anpressdruck an der in der Aufnahme befindlichen Kontaktfläche an.

Zum anderen lässt sich der erfindungsgemäße Schaltungsträger auch wie folgt herstellen. Bereits bei der Platzierung der Schaltungsträgerfolie auf dem Trägerelement wird die flexible Kontaktfläche in die Aufnahme gelegt. Falls notwendig kann die Kontaktfläche dabei in der Aufnahme befestigt werden. Anschließend wird dann wiederum das Kontaktelement in die Aufnahme eingeführt. Dabei liegt nach der Montage das Kontaktelement mit einem Anpressdruck an der in der Aufnahme befindlichen Kontaktfläche an.

Die beiden Herstellverfahren für den erfindungsgemäßen Schaltungsträger zeichnen sich durch Einfachheit und Kostengünstigkeit aus.

Die mit der Erfindung erzielten Vorteile bestehen insbesondere darin, dass für den Schaltungsträger eine Kontaktierung ohne Verwendung von Zusatzstoffen, wie Lötzinn, Leitkleber o. dgl., erreicht wird. Außerdem entfällt ein zusätzlicher Verbindungsarbeitsgang, beispielsweise Schweißen oder Aufheizen. Das gewährleistet zum einen eine verbesserte Umweltverträglichkeit sowie zum anderen die Einsparung von Kosten. Darüber hinaus wird eine gute Funktionssicherheit auch in rauhen Umgebungsbedingungen, beispielsweise beim Einsatz in Kraftfahrzeugen, erzielt.

Ausführungsbeispiele der Erfindung sind in den Zeichnungen dargestellt und werden im Folgenden näher beschrieben. Es zeigen
Fig. 1 einen Elektrokomponententräger in Seitenansicht,
Fig. 2 eine Draufsicht auf die Schaltungsträgerfolie,
Fig. 3 eine Detailansicht des Elektrokomponententrägers, wobei der Kontaktanschluss
   noch nicht montiert ist,
Fig. 4 eine Detailansicht des Elektrokomponententrägers, wobei der Kontaktanschluss
   entsprechend einer ersten Ausführungsform montiert ist,
Fig. 5 das Trägerelement des Elektrokomponententrägers in räumlicher Darstellung,
Fig. 6 den Kontaktanschluss wie in Fig. 4 in einer weiteren Ausgestaltung,
Fig. 7 den Kontaktanschluss wie in Fig. 4 in noch einer weiteren Ausgestaltung und
Fig. 8 einen elektrischen Schalter mit einem als Kontaktanschluss ausgebildeten
   elektrischen Anschluss.

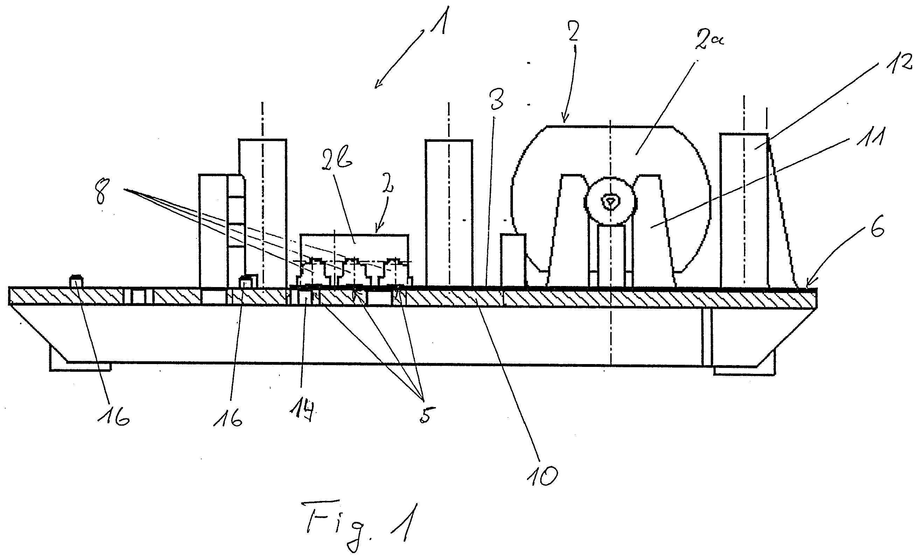

In Fig. 1 ist ein Elektrokomponententräger 1 mit elektrischen, elektronischen o. dgl. Bauteilen 2, und zwar einem Elektromotor 2a sowie einem elektrischen Schalter 2b zu sehen. Selbstverständlich können auf dem Elektrokomponententräger 1 noch weitere Bauteile 2, wie Widerstände, Kondensatoren, Spulen, ICs, Steckanschlüsse o. dgl. angeordnet sein. Solche Elektrokomponententräger 1 werden in Steuergeräten in Kraftfahrzeugen, beispielsweise in Türsteuergeräten von Zentralverriegelungen, eingesetzt.

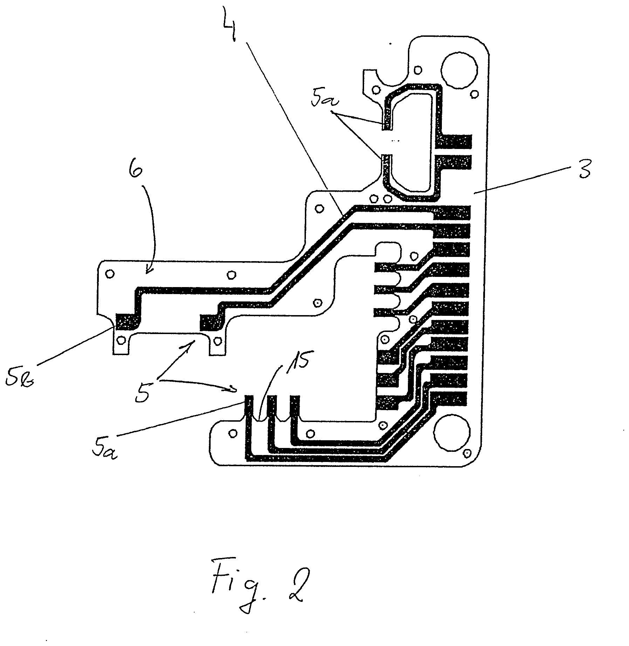

Die Bauteile 2 sind in einer elektrischen Schaltung miteinander verbunden. Für diese elektrische Schaltung besitzt der Elektrokomponententräger 1 einen Schaltungsträger 3. Der Schaltungsträger 3 weist in Fig. 2 sichtbare Leiterbahnen 4 zur elektrischen Verbindung der Bauteile 2 sowie Kontaktflächen 5 zur elektrischen Kontaktierung der Bauteile 2 auf. Die Kontaktflächen 5 sind wiederum mittels Kontaktelementen 8 mit den Bauteilen 2 elektrisch verbunden.

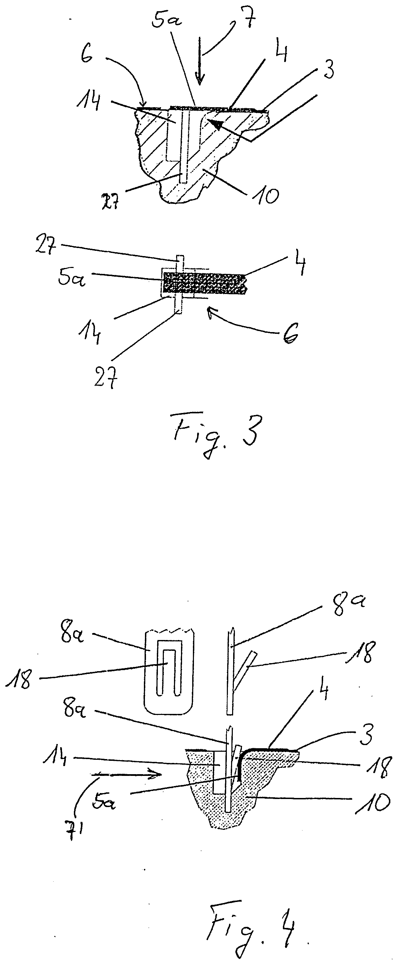

In einer ersten Ausführungsform, die in Fig. 2 zu sehen ist, ist die Kontaktfläche 5a wenigstens teilweise in der Ebene 6 des Schaltungsträgers 3 freigeschnitten und bildet so eine Art von Kontaktzunge oder Kontaktlappen. Dadurch weist die Kontaktfläche 5a eine Flexibilität in eine außerhalb der Ebene 6 des Schaltungsträgers 3 verlaufende Richtung 7 auf. Wie man vor allem anhand der Fig. 3 erkennt, steht diese Richtung 7 in etwa senkrecht zur Ebene 6. Das Kontaktelement 8a zur elektrischen Kontaktierung des Bauteils 2 liegt mit einem Anpressdruck derart an der Kontaktfläche 5a an, dass die Kontaktfläche 5a aus der Ebene 6 des Schaltungsträgers 3 ausgelenkt ist, wie anhand von Fig. 4 zu erkennen ist. Der Anpressdruck durch das Kontaktelement 8a wird im Wesentlichen in eine parallel zur Ebene 6 des Schaltungsträgers 3 verlaufende Richtung 7' ausgeübt.

Wie ebenfalls in Fig. 2 zu sehen ist, ist die Kontaktfläche 5b wenigstens teilweise in der Ebene 6 des Schaltungsträgers 3 freiliegend angeordnet.
Um die gewünschte Flexibilität der Kontaktflächen 5a zu erzielen, bietet es sich an, als Schaltungsträger 3 eine wenigstens teilweise flexible Leiterplatte zu verwenden. Zweckmäßigerweise handelt es sich dann bei dem Schaltungsträger 3 um eine flexible Schaltungsträgerfolie. Die Schaltungsträgerfolie 3 besteht aus Polyimid, wobei auf der Oberfläche der Schaltungsträgerfolie 3 die Leiterbahnen 4 sowie die Kontaktflächen 5 aus Kupfer in herkömmlicher Additiv- und/oder Subtraktiv-Technik aufgebracht sind. Die Kontaktflächen 5 sind als freigeschnittenes und/oder freiliegendes Ende einer Leiterbahn 4 ausgestaltet, wie anhand der Kontaktflächen 5a, 5b in Fig. 2 zu sehen ist. Um ein Einreißen der Schaltungsträgerfolie 3 beim Auslenken der Kontaktfläche 5a durch das Kontaktelement 8a mit Sicherheit zu verhindern, kann der Zungengrund 15 der freigeschnittenen Kontaktfläche 5a abgerundet sein, wie in Fig. 2 zu erkennen ist.

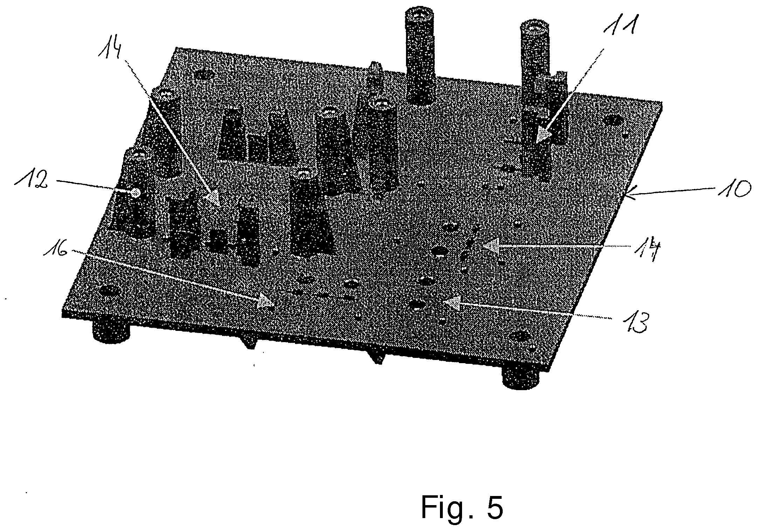

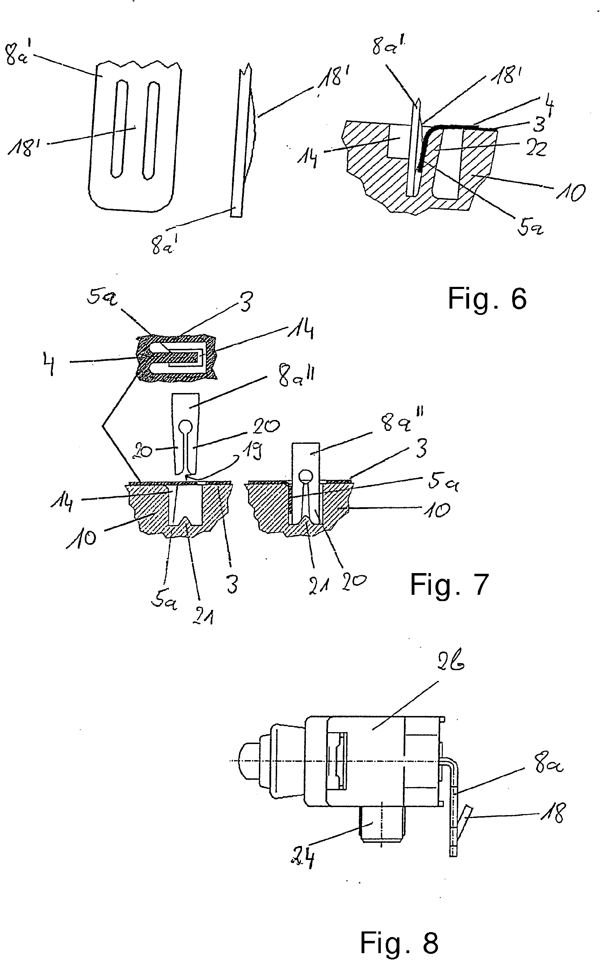

Zwecks Erzielung einer gewissen Stabilität des Elektrokomponententrägers 1 ist die Schaltungsträgerfolie 3 an einem Trägerelement 10 angeordnet. Das in Fig. 5 gezeigte Trägerelement 10 besteht aus Kunststoff, beispielsweise Polyamid, und ist in Spritzgießtechnik hergestellt. Das Trägerelement 10 besitzt Rast-/Schnapp-Haken 11 zur Befestigung der Elektromotoren 2a sowie Befestigungsdome 12 für die Verschraubung von nicht weiter gezeigten Deckplatten, die die Elektromotoren 2a niederhalten. Das Trägerelement 10 besitzt weiter Löcher 13, in die der Schalter 2b mittels entsprechender, in Fig. 8 sichtbarer Rastzapfen 24 an dessen Gehäuse in bekannter Weise fixierend einsteckbar ist.

Die Schaltungsträgerfolie 3 ist auf dem Trägerelement 10 befestigt. Bei der Herstellung des Trägerelements 10 kann durch Spritzgießen gleichzeitig die Schaltungsträgerfolie 3 mit hinterspritzt werden.
Schließlich sind im Trägerelement 10 noch Aufnahmen 14 beziehungsweise Ausnehmungen, Ausformungen o. dgl. für die Kontaktelemente 8 angebracht. Bei der ersten Ausführungsform ragt, wie in Fig. 3 zu sehen ist, die Kontaktfläche 5a nach der Befestigung der Schaltungsträgerfolie 3 auf dem Trägerelement 10 in diese Aufnahme14 hinein. Zur elektrischen Verbindung unter Auslenkung der Kontaktflächen 5a ist das Kontaktelement 8a kraft- und/oder formschlüssig derart in Aufnahme 14 eingesteckt, dass das Kontaktelement 8a an der freigeschnittenen Kontaktfläche 5a anliegt, wie in Fig. 4 zu sehen ist. Das Einstecken des Kontaktelements 8a in die Aufnahme 14 wird durch eine entsprechende, in Fig. 3 sichtbare Führung 27 in der Aufnahme 14 erleichtert
Das Kontaktelement 8 kann in der Art eines Steckverbinders ausgestaltet sein. Als Material für das Kontaktelement 8 bietet sich Bronzeblech an, wobei gegebenenfalls dessen Oberfläche verzinnt sein kann. Bei der ersten Ausführungsform weist das Kontaktelement 8a einen wenigstens teilweise freigeschnittenen Abschnitt 18 auf. Wie insbesondere in Fig. 4 zu sehen ist, ist in das Kontaktelement 8a ein in etwa U-förmiger Einschnitt für den Abschnitt 18 eingebracht. Der Abschnitt 18 ist anschließend derart ausgeklinkt, dass dieser in der Art einer federartigen Zunge, eines federnden Schenkels o. dgl. wirkt. Nach dem Einstecken des Kontaktelements 8a in die Aufnahme 14 liegt dann der Abschnitt 18 mit einer Andrückkraft zur Kontaktgabe an der Kontaktfläche 5a an.

In einer weiteren Ausgestaltung gemäß Fig. 6 ist der Abschnitt 18' am Kontaktelement 8a' lediglich mit zwei parallelen Strecken freigeschnitten und anschließend durch plastische Verformung ausgebeult. In der Aufnahme 14 befindet sich ein federnder Steg 22, der die Kontaktfläche 5a an den Abschnitt 18' andrückt. In noch einer weiteren Ausgestaltung gemäß Fig. 7 ist das Kontaktelement 8a'' klemmenartig freigeschnitten. Das Kontaktelement 8a'' ist mit seiner Klemmenseite 19 derart auf eine keilförmige Erhöhung 21 in der Aufnahme 14 aufgesteckt, dass die Schenkel 20 an der Klemmenseite 19 auseinandergespreizt werden und einer der Schenkel 20 mit einer Anpresskraft zur Kontaktgabe an der Kontaktfläche 5a anliegt. Die keilförmige Erhöhung 21, der federnde Steg 22 o. dgl. in der Aufnahme 14 dienen damit zur Ausübung und/oder Erhöhung der Anpresskraft des freigeschnittenen Abschnittes 18, 18' oder des Schenkels 20 an die Kontaktfläche 5a.

Das Kontaktelement 8 kann am Bauteil 2 befestigt oder ein bezüglich des Bauteils 2 separates Teil sein. Der erste Fall ist anhand des Schalters 2b in Fig. 8 verdeutlicht, wo der elektrische Anschluss des Schalters 2b als ein Kontaktelement 8a mit federndem, freigeschnittenem Abschnitt 18 ausgestaltet ist.

Zur Herstellung eines erfindungsgemäßen Elektrokomponententrägers 1 bietet sich nachfolgendes Verfahren an. Zunächst wird die Schaltungsträgerfolie 3 auf dem Trägerelement 10 angeordnet, wobei die Kontaktfläche 5 an der Aufnahme 14 im Trägerelement 10 positioniert wird. Anschließend wird das Kontaktelement 8 zur Montage in die Aufnahme 14 eingeführt. Dabei zieht das Kontaktelement 8 die Kontaktfläche 5 in die Aufnahme 14 mit hinein. Befindet sich das Kontaktelement 8 nach der Montage in der Aufnahme 14, so liegt das Kontaktelement 8 mit einem Anpressdruck an der in der Aufnahme 14 befindlichen Kontaktfläche 5 an. Alternativ kann die Kontaktfläche 5 bei Befestigung der Schaltungsträgerfolie 3 auf dem Trägerelement 10 bereits in die Aufnahme 14 gelegt und gegebenenfalls in dieser befestigt werden. Nach der Montage des Kontaktelements 8 durch Einführen in die Aufnahme 14 liegt dieses dann mit einem Anpressdruck an der in der Aufnahme 14 befindlichen Kontaktfläche 5 an.

Die Erfindung ist nicht auf die beschriebenen und dargestellten Ausführungsbeispiele beschränkt. Sie umfasst vielmehr auch alle fachmännischen Weiterbildungen im Rahmen der durch die Patentansprüche definierten Erfindung. So kann ein derartiger Elektrokomponententräger 1 nicht nur in Türsteuergeräten sondern auch in sonstigen Steuergeräten für Kraftfahrzeuge, wie Fensterheber, Spiegelverstellungen o. dgl., eingesetzt werden. Schließlich kann der Elektrokomponententräger 1 nicht nur in Kraftfahrzeugen sondern auch in Elektrogeräten, Haushaltsgeräten, Werkzeugmaschinen o. dgl. Verwendung finden.

### Bezugszeichenliste:

- 1:: Elektrokomponententräger
- 2:: elektrisches / elektronisches Bauteil
- 2a:: Elektromotor
- 2b:: elektrischer Schalter
- 3:: Schaltungsträger / Schaltungsträgerfolie
- 4:: Leiterbahn
- 5:: Kontaktfläche
- 5a:: freigeschnittene Kontaktfläche
- 5b:: freiliegende Kontaktfläche
- 6:: Ebene (des Schaltungsträgers)
- 7:: Richtung (für Flexibilität des Schaltungsträgers)
- 7':: Richtung (für Anpressdruck)
- 8:: Kontaktelement
- 8a:: Kontaktelement (für freigeschnittene Kontaktfläche)
- 8a':: Kontaktelement (weitere Ausgestaltung)
- 8a":: Kontaktelement (noch weitere Ausgestaltung)
- 8b:: Kontaktelement (für freiliegende Kontaktfläche)
- 9,9':: Auflagefuß (von Kontaktelement)
- 10:: Trägerelement (für Elektrokomponententräger)
- 11:: Rast-/Schnapp-Haken (an Trägerelement)
- 12:: Befestigungsdom (an Trägerelement)
- 13:: Loch (in Trägerelement)
- 14:: Aufnahme (in Trägerelement)
- 15:: Zungengrund (von freigeschnittener Kontaktfläche)
- 16:: Fixierzapfen (für Schaltungsträgerfolie)
- 17:: Verzahnung
- 18:: (freigeschnittener) Abschnitt (an Kontaktelement)
- 18':: (freigeschnittener) Abschnitt (gemäß noch weiterer Ausgestaltung)
- 19:: Klemmenseite (an Kontaktelement gemäß weiterer Ausgestaltung)
- 20:: Schenkel (an Kontaktelement gemäß weiterer Ausgestaltung)
- 21:: keilförmige Erhebung (in Aufnahme)
- 22:: federnder Steg (in Aufnahme)
- 23:: Schneidklemm-Kontaktierung (an Kontaktelement)
- 24:: Rastzapfen
- 25:: Fixierloch (in Schaltungsträgerfolie)
- 26:: Stempel
- 27:: Führung (in der Aufnahme)

## Patentansprüche

1. Elektrische Schaltung mit einem Schaltungsträger (3), insbesondere in der Art einer wenigstens teilweise flexiblen Leiterplatte, und mit elektrischen, elektronischen o. dgl. Bauteilen (2), wie einen Elektromotor (2a), Schalter (2b), Widerstand, Kondensator, Spule, IC, Steckanschluss o. dgl., wobei es sich bei dem Schaltungsträger (3) um eine flexible, an einem Trägerelement (10) angeordnete Schaltungsträgerfolie handelt, wobei der Schaltungsträger (3) Leiterbahnen (4) zur elektrischen Verbindung der Bauteile (2) sowie Kontaktflächen (5a) zur elektrischen Kontaktierung der Bauteile (2) aufweist, wobei die Kontaktfläche (5a) wenigstens teilweise in der Ebene (6) des Schaltungsträgers (3) freigeschnitten ist, derart dass die Kontaktfläche (5a) eine Flexibilität in eine außerhalb der Ebene (6) des Schaltungsträgers (3) verlaufende Richtung (7) in der Art einer Kontaktzunge aufweist, und wobei ein in der Art eines Steckverbinders ausgestaltetes Kontaktelement (8a, 8a', 8a'') zur elektrischen Kontaktierung des Bauteils (2) mit einem Anpressdruck derart an der Kontaktfläche (5a) anliegt, dass die Kontaktfläche (5a) aus der Ebene (6) des Schaltungsträgers (3) ausgelenkt ist und dass das Kontaktelement (8a, 8a', 8a'') am Bauteil (2) befestigt ist, **dadurch gekennzeichnet, dass** die Schaltungsträgerfolie (3) auf dem aus Kunststoff bestehenden Trägerelement (10) durch Hinterspritzen befestigt ist, dass das Kontaktelement (8a, 8a', 8a'') einen wenigstens teilweise freigeschnittenen Abschnitt (18, 18') aufweist, dass der Abschnitt (18, 18') derart ausgeklinkt ist, dass dieser in der Art einer federartigen Zunge oder eines federnden Schenkels (20) wirkt, dass der Abschnitt (18, 18') zur Kontaktgabe mit einer Andrückkraft an die Kontaktfläche (5a) anliegt und dass das Trägerelement (10) Rast-/Schnapphaken (11) zur Befestigung von Elektromotoren (2a) und/oder Befestigungsdome (12) für die Verschraubung von Deckplatten, die die Elektromotoren (2a) niederhalten und/oder Löcher (13), in die ein Schalter (2b) mittels Rastzapfen (24) an dessen Gehäuse fixierend einsteckbar ist, aufweist.

2. Elektrische Schaltung nach Anspruch 1, **dadurch gekennzeichnet, dass** die Kontaktfläche (5a) als freigeschnittenes Ende einer Leiterbahn (4) ausgestaltet ist.

3. Elektrische Schaltung nach Anspruch 1 oder 2, **dadurch gekennzeichnet, dass** im Trägerelement (10) eine Aufnahme (14) angebracht ist, dass vorzugsweise die Kontaktfläche (5a) in die Aufnahme (14) hineinragt, und dass weiter vorzugsweise das Kontaktelement (8) kraft- und/oder formschlüssig, derart in die Aufnahme (14) eingesteckt ist, dass das Kontaktelement (8) an der Kontaktfläche (5) anliegt.

4. Elektrische Schaltung nach Anspruch 1, 2 oder 3, **dadurch gekennzeichnet, dass** der Abschnitt (18, 18') des Kontaktelements (8) in der Aufnahme (14) befindlich ist, und dass vorzugsweise in der Aufnahme eine keilförmige Erhöhung (21), ein federnder Steg (22) o. dgl. zur Ausübung und/oder Erhöhung der Anpresskraft des freigeschnittenen Abschnittes (18, 18') an die Kontaktfläche (5a) angeordnet ist.

5. Verfahren zur Herstellung einer elektrischen Schaltung nach einem der vorangehenden Ansprüche, **dadurch gekennzeichnet, dass** das am Bauteil (2) befestigte Kontaktelement (8a, 8a', 8a'') in die Aufnahme (14) eingeführt wird, und dass das Kontaktelement (8a, 8a', 8a'') bei der Montage die Kontaktfläche (5a) in die Aufnahme (14) mit hineinzieht oder dass die Kontaktfläche (5a) bereits bei Befestigung der Schaltungsträgerfolie (3) auf dem Trägerelement (10) in die Aufnahme (14) gelegt sowie gegebenenfalls befestigt wird, derart dass nach der Montage das Kontaktelement (8a, 8a', 8a'') mit einem Anpressdruck an der in der Aufnahme (14) befindlichen Kontaktfläche (5a) anliegt.

## Claims

1. An electrical circuit having a circuit carrier (3), in particular in the form of an at least partially flexible printed circuit board, and having electrical, electronic or similar components (2), such as an electric motor (2a), switch (2b), resistor, capacitor, coil, IC, plug connection or the like, wherein the circuit carrier (3) is a flexible circuit carrier film, arranged on a carrier element (10), wherein the circuit carrier (3) has conductor tracks (4) for electrically connecting the components (2) as well as contact surfaces (5a) for electrically contacting the components (2), wherein the contact surface (5a) is at least partially cut free in the plane (6) of the circuit carrier (3) such that the contact surface (5a) has a flexibility in a direction (7) extending outside of the plane (6) of the circuit carrier (3) in the manner of a contact blade, and wherein a contact element (8a, 8a', 8a"), configured in the manner of a plug-in connector, for electrical contacting the component (2) abuts the contact surface (5a) with a contact pressure such that the contact surface (5a) is deflected from the plane (6) of the circuit carrier (3) and that the contact element (8a, 8a', 8a") is fastened to the component (2), **characterised in that** the circuit carrier film (3) is fastened to the plastics carrier element (10) by back injection moulding, **in that** the contact element (8a, 8a', 8a") has an at least partially cut-free portion (18, 18'), **in that** the portion (18, 18') is notched in such a way that it acts in the manner of a spring-like tongue or a resilient leg (20), **in that** the portion (18, 18') for providing contact abuts the contact surface (5a) with a pressing force, and **in that** the carrier element (10) has latch/snap hooks (11) for fastening electric motors (2a) and/or fastening domes (12) for screwing down cover plates that hold down the electric motors (2a), and/or holes (13) into which a switch (2b) is insertable in a securing manner by means of latching pins (24) on its housing.

2. The electrical circuit according to claim 1, **characterised in that** the contact surface (5a) is configured as a cut-free end of a conductor track (4).

3. The electrical circuit according to claim 1 or 2, **characterised in that** a receptacle (14) is attached in the carrier element (10), **in that** the contact surface (5a) preferably projects into the receptacle (14), and more preferably **in that** the contact element (8) is inserted into the receptacle (14) in a force-fit and/or form-fit manner such that the contact element (8) abuts the contact surface (5).

4. The electrical circuit according to claim 1, 2, or 3, **characterised in that** the portion (18, 18') of the contact element (8) is located in the receptacle (14), and preferably **in that** a wedge-shaped ridge (21), a resilient web (22) or the like is arranged in the receptacle for applying and/or increasing the contact force of the cut-free portion (18, 18') on the contact surface (5a).

5. A method for producing an electrical circuit according to one of the preceding claims, **characterised in that** the contact element (8a, 8a', 8a") fastened to the component (2) is inserted into the receptacle (14), and **in that**, during assembly, the contact element (8a, 8a', 8a") pulls the contact surface (5a) along into the receptacle (14) or **in that** the contact surface (5a) is already placed in, and optionally fastened to, the receptacle (14) when the circuit carrier film (3) is being fastened to the carrier element (10) such that, after assembly, the contact element (8a, 8a', 8a") abuts the contact surface (5a) located in the receptacle (14) with a contact pressure.

## Revendications

1. Circuit électrique comportant un porteur du circuit (3), notamment sous la forme d'une carte de circuit imprimé au moins partiellement flexible et comportant des composants électriques, électroniques ou similaires (2), tels qu'un moteur électrique (2a), un commutateur (2b), une résistance, un condensateur, une bobine, un IC, un connexion enfichable ou similaire, le porteur du circuit (3) est une feuille flexible portante du circuit disposée sur un élément de support (10), le porteur du circuit (3) présentant des pistes conductrices (4) pour la connexion électrique des composants (2) et des surfaces de contact (5a) pour mettre en contact électrique les composants (2), la surface de contact (5a) étant au moins partiellement libre dans le plan (6) du porteur du circuit (3), de sorte que la surface de contact (5a) présente une souplesse dans une direction (7) s'étendant hors du plan (6) du porteur du circuit (3) à la manière d'une languette de contact et un élément de contact (8a, 8a', 8a") conçu sous la forme d'un connecteur enfichable étant présent pour la mise en contact électrique du composant (2) avec une pression de contact sur la surface de contact (5a) de sorte que la surface de contact (5a) soit déviée depuis le plan (6) du porteur du circuit (3) et que l'élément de contact (8a, 8a', 8a") soit fixé sur le composant (2), **caractérisé en ce que** la feuille de dispositif interconnecté (3) est fixée sur l'élément de support (10) constitué de plastique par injection par l'arrière, **en ce que** l'élément de contact (8a, 8a', 8a") présente une section (18, 18') au moins partiellement libre, **en ce que** la section (18, 18') est décrochée de telle sorte qu'elle agisse à la manière d'une languette en forme de ressort ou d'une jambe élastique (20), **en ce que** la section (18, 18') repose pour une mise en contact avec une force de pression contre la surface de contact (5a) et **en ce que** l'élément de support (10) présente un crochet à encliquetage/à déclic (11) pour la fixation de moteurs électriques (2a) et/ou de plots de fixation (12) pour le vissage de plaques de recouvrement, qui retiennent les moteurs électriques (2a) et/ou des trous (13) dans lesquels un commutateur (2b) peut être inséré au moyen d'une broche d'encliquetage (24) sur leurs boîtiers.

2. Circuit électrique selon la revendication 1, **caractérisé en ce que** la surface de contact (5a) est conçue comme une extrémité libre d'une piste conductrice (4).

3. Circuit électrique selon la revendication 1 ou 2, **caractérisé en ce que** dans l'élément de support (10) est monté un logement (14), **en ce que** de préférence la surface de contact (5a) fait saillie dans le logement (14) et **en ce que**, de préférence encore, l'élément de contact (8) est inséré dans le logement (14) par complémentarité de forme et/ou par friction, de manière à ce que l'élément de contact (8) repose contre la surface de contact (5).

4. Circuit électrique selon la revendication 1, 2 ou 3, **caractérisé en ce que** la section (18, 18') de l'élément de contact (8) se trouve dans le logement (14) et **en ce que** de préférence, une élévation en forme de coin (21), un élément de liaison élastique (22) ou similaire est agencé(e) dans le logement pour exercer et/ou augmenter la pression de contact de la section libre (18, 18') sur la surface de contact (5a).

5. Procédé de fabrication d'un circuit électrique selon l'une des revendications précédentes, **caractérisé en ce que** l'élément de contact (8a, 8a', 8a") fixé au composant (2) est introduit dans le logement (14) et **en ce que** l'élément de contact (8a, 8a', 8a") lors de l'assemblage, entraîne la surface de contact (5a) dans le logement (14) avec lui ou **en ce que** la surface de contact (5a) est déjà présente lors de la fixation de la feuille portante du circuit (3) sur l'élément de support (10) dans le logement (14) et éventuellement fixée de manière à ce que, après l'assemblage, l'élément de contact (8a, 8a', 8a") soit soumis à une pression de contact sur la surface de contact (5a) située dans le logement (14).
